# EUROPEAN PATENT APPLICATION

(11) **EP 1 744 370 A2**
(43) Date of publication of application: **17.01.2007**
(21) Application number: 06253411.0
(22) Date of filing: 29.06.2006
(51) Int. Cl.: H01L 27/28, G11C 13/02

(54) **Electric field programmable films and memory devices based thereon**

(30) Priority: 08.07.2005 US 697604 P; 17.03.2006 US 384059
(71) Applicant: Rohm and Haas Electronic Materials LLC, Marlborough, MA 01752 (US)
(72) Inventor: Chandross, Edwin A., Murray Hill, New Jersey 07974 (US); Cutler, Charlotte, Waltham, Massachusetts 02453 (US); Greer, Edward C., Lower Gwynedd, Pennsylvania 19002 (US); Szmanda, Charles R., Westborough, Massachusetts 01581 (US); Truong, Chi Q., Westborough, Massachusetts 01581 (US)
(74) Representative: Kent, Venetia Katherine

(57) **Abstract**

An electric field programmable film composition is disclosed containing a binder and (a) an electron donor and an electron acceptor, wherein at least one of: (i) the concentration of the electron donor is <0.05 wt% and (ii) the concentration of the electron acceptor is <0.05 wt% or (b) an electron donor and an electron acceptor, wherein the electron donor and/or the electron acceptor is chemically bound to the binder. Also disclosed are methods for manufacturing an electric field programmable film on a substrate. Also disclosed are memory devices, wherein the memory device comprises an electric field programmable film.

## Description

The present invention relates to electric field programmable film compositions, memory devices based thereon and machines comprising such devices.

Electronic memory and switching devices are presently made from inorganic materials such as crystalline silicon. Although these devices have been technically and commercially successful, they have a number of drawbacks, including complex architectures and high fabrication costs. In the case of volatile semiconductor memory devices, the circuitry must constantly be supplied with a current in order to maintain the stored information. This results in heating and high power consumption. Non-volatile semiconductor devices avoid this problem but have reduced data storage capability as a result of higher complexity in the circuit design, which consequently results in higher production costs.

Alternative electronic memory and switching devices employ a bistable element that can be converted between a high impedance state and a low impedance state by applying an electrical current or other type of input to the device. Both organic and inorganic thin-film semiconductor materials can be used in electronic memory and switching devices, for example in thin, binderless films of amorphous chalcogenide semiconductor organic charge-transfer complexes such as copper-7,7,8,8-tetracyanoquinodimethane (Cu-TCNQ) thin films, and in certain inorganic oxides in organic matrices. These materials have been proposed as potential candidates for nonvolatile memories.

Several volatile and nonvolatile memory elements have been implemented at the grid intersection points using various bistable materials. However, many currently known bistable films are inhomogeneous, multilayered composite structures fabricated by evaporative methods, which are expensive and can be difficult to control. In addition, these bistable films do not afford the opportunity for fabricating films in topographies ranging from conformal to planar. Bistable films fabricated using polymer matrices and particulate matter are generally inhomogeneous and therefore unsuitable for fabricating submicrometer and nanometer-scale electronic memory and switching devices. Still other bistable films can be controllably manufactured by standard industrial methods, but their operation requires high temperature melting and annealing at the grid intersection points. Such films generally suffer from thermal management problems, have high power consumption requirements, and afford only a small degree of differentiation between the "conductive" and "nonconductive" states. Furthermore, because such films operate at high temperatures, it is difficult to design stacked device structures that allow high density memory storage.

Accordingly, there remains a need in the art for improved electric field programmable films.

In one aspect of the present invention, there is provided an electric field programmable film composition comprising a formulation selected from formulation A and formulation B; wherein formulation A comprises a binder, an electron donor and an electron acceptor; where at least one of the electron donor and the electron acceptor is chemically bound to the binder; and, wherein formulation B comprises a binder, an electron donor and an electron acceptor; wherein formulation B contains less than 0.05 wt% of at least one of the electron donor and the electron acceptor.

In another aspect of the present invention, there is provided a method for preparing an electric field programmable film comprising depositing on a substrate an electric field programmable film composition of the present invention.

In another aspect of the present invention, there is provided a memory device comprising an electric field programmable film of the present invention.

In another aspect of the present invention, there is provided a machine comprising a memory device of the present invention.

The term "chemically bonded" as used herein and in the appended claims encompasses covalently bonded, ionically bonded and hydrogen bonded.

The term "derivatives" as used herein and in the appended claims, in reference to an electron donor or an electron acceptor, encompasses chemical modifications and analogs of the referenced electron donor or electron acceptor such as, for example, isomers, chemical substitutions, and instances in which the electron donor or electron acceptor is chemically bonded to a binder or incorporated into the binder as a monomer unit.

In some embodiments, the binder exhibits a dielectric constant of 2 to 1000.

In some embodiments, the binder exhibits sufficient chemical and thermal resistance to withstand processes involving the deposition of metals, etch barrier layers, seed layers, metal precursors, photoresists and antireflective coatings.

In some embodiments, the binder imparts a low level of electrical conductivity to the electric field programmable film in the "off" state and permits for a sufficiently high concentration of electron donors and electron acceptors to enable a sufficiently high conductivity in the "on" state so that the difference between the "off" state and the "on" state is readily discerned. In some aspects of these embodiments, the electrical conductivity of the binder is less than or equal to about 10⁻¹⁰ ohm⁻¹cm⁻¹. In some aspects of these embodiments, the binder provides for the ratio of the electrical current in the "on" state to that in the "off" state to be ≥ 5, alternatively ≥ 100, alternatively ≥ 500.

In some embodiments of the present invention, the binder may include, for example, oligomers, polymers, ionomers, dendrimers, copolymers such as block and random copolymers, graft copolymers, star block copolymers, inorganics, partially inorganics, and combinations thereof.

In some embodiments of the present invention, the binder may chemically bond; alternatively covalently bond, to either or both of the electron donor and the electron acceptor. In some aspects of these embodiments, the electron donor and/or the electron acceptor may be chemically bonded to at least one segment of the binder. In some aspects of these embodiments, the electron donor and/or the electron acceptor may be covalently bonded to at least one segment of the binder.

In some embodiments of the present invention, the binder may be selected from polymers including, for example, polyacetals, polyacrylics, polycarbonates, polystyrenes, polyesters, polyamides, polyamideimides, polyarylates, polyarylsulfones, polyethersulfones, polyphenylene sulfides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, polycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, polysiloxanes, and combinations thereof.

In some embodiments of the present invention, the binder may be a copolymer selected from, for example, copolyestercarbonates, acrylonitrile butadiene styrene, styrene acrylonitrile, polyimide-polysiloxane, polyester-polyetherimide, polymethylmethacrylate-polysiloxane, polyurethane-polysiloxane, and combinations thereof.

In some embodiments of the present invention, the binder may be selected from mixtures of polymers. In some aspects of these embodiments the polymers may be crosslinkable. In some aspects of these embodiments, the binder may comprise at least two polymers, wherein one of the at least two polymers is chemically bound, alternatively covalently bound, to an electron donor and/or an electron acceptor and wherein one of the at least two polymers is not chemically bound, alternatively covalently bound, to either electron donor or electron acceptor. In some aspects of these embodiments, the binder may comprise at least two polymers, wherein one of the at least two polymers is chemically bound, alternatively covalently bound, to an electron donor and another one of the at least two polymers is chemically bound, alternatively covalently bound, to an electron acceptor. Such mixtures of polymers may be employed to fine tune the properties of the electric field programmable film. For example, the polymer mixture may be used to balance the charge carrier density in a given electric field programmable film composition.

In some embodiments of the present invention, the binder is a mixture of polymers. In some aspects of these embodiments, the binder may be selected from a mixture of polymers selected from, for example, acrylonitrile-butadiene-styrene/nylon, polycarbonate/acrylonitrile-butadiene-styrene, acrylonitrile butadiene styrene/polyvinyl chloride, polyphenylene ether/polystyrene, polyphenylene ether/nylon, polysulfone/acrylonitrile-butadiene-styrene, polycarbonate/thermoplastic urethane, polycarbonate/polyethylene terephthalate, polycarbonate/polybutylene terephthalate, thermoplastic elastomer alloys, nylon/elastomers, polyester/elastomers, polyethylene terephthalate/polybutylene terephthalate, acetal/elastomer, styrene-maleicanhydride/acrylonitrile-butadiene-styrene, polyether etherketone/polyethersulfone, polyethylene/nylon, polyethylene/polyacetal, and combinations thereof.

In some embodiments of the present invention, the binder may be an inorganic or partially inorganic material. In some aspects of these embodiments, the binder may comprise a silicone, silsesquioxane and combinations thereof.

In some embodiments of the present invention, the binder is functionalized to facilitate at least one of crosslinking, chemical bonding with an electron donor, chemical bonding with an electron acceptor, covalent bonding with an electron donor and covalent bonding with an electron acceptor.

In some embodiments of the present invention, the binder is a polymer or combination of polymers having a number average molecular weight of 500 to 1,000,000 grams/mole; alternatively 3,000 to 500,000 grams/mole; alternatively 5,000 to 100,000 grams/mole; alternatively 10,000 to 30,000 grams/mole.

In some embodiments of the present invention, the binder may be crosslinked. In some aspects of these embodiments, the crosslinking may be brought about by reactions at functional groups chemically bonded, alternatively covalently bonded, to the backbone of the binder. In some aspects of these embodiments, the crosslinking may occur through noncovalent bonding. In some aspects of these embodiments, the binder may be crosslinked using a crosslinking agent including, for example, a silane, an ethylenically unsaturated resin, an aminoplast resin, a phenolic, a phenol-formaldehyde resin, an epoxy, and combinations thereof.

In some embodiments of the present invention, the electric field programmable film composition comprises a crosslinking agent. In some aspects of these embodiments, the electric field programmable film composition contains 0.01 to 20 wt%, alternatively 0.1 to 15 wt%, alternatively 0.5 to 10 wt%, alternatively 1 to 7 wt% crosslinking agents (based on total solids).

In some embodiments of the present invention, the electric field programmable film composition may comprise an, optional, acid and/or acid generator. The addition of an acid and/or an acid generator may catalyze or promote crosslinking of the binder during curing of the electric field programmable film composition. In some aspects of these embodiments, the acid may be selected from, for example, aromatic sulfonic acids (e.g., toluene sulfonic acid, benzene sulfonic acid, p-dodecylbenzene sulfonic acid); fluorinated alkyl or aromatic sulfonic acids (e.g., o-trifluoromethylbenzene sulfonic acid, triflic acid, perfluoro butane sulfonic acid, perfluoro octane sulfonic acid); and combinations thereof. In some aspects of these embodiments, the acid generator may be a thermal acid generator selected from, for example, 2,4,4,6-tetrabromocyclohexadienone; benzoin tosylate; 2-nitrobenzyl tosylate; 4-nitrobenzyl tosylate; and combinations thereof. In some aspects of these embodiments, the electric field programmable film composition may contain 0.01 to 10 wt%, alternatively 0.1 to 8 wt%, alternatively 0.5 to 5 wt%, alternatively 1 to 3 wt% acid generator (based on total solids).

In some embodiments of the present invention, the electron donor may be selected from, for example, anthracene; tetrathiafulvalene; 4,4',5-trimethyltetrathiafulvalene; bis(ethylenedithio)tetrathiafulvalene; p-phenylenediamine; carbazole; substituted carbazole (e.g., N-vinyl carbazole); tetrathiotetracene; hexamethylbenzene; tetramethyltetraselenofulvalene; hexamethylenetetraselenofulvalene; 8-hydroxyquinoline; phenyl azorecorcinol and similar azo dyes; N,N'-bis (3-methylphenyl)-N,N'-diphenylbenzidine; phenothiazine; substituted phenothiazines (e.g., N-vinyl phenothiazine); pyrene; acenaphthylene; acridine; triphenylene; phthalocyanine; 2-amino-1H-imidazole-4,5-dicarbonitrile (AIDCN); substituted AIDCN (e.g., N-vinyl AIDCN); derivatives thereof; and combinations thereof.

In some embodiments of the present invention, the electron donor may be an electron donor derivative chemically bound to a binder (hereinafter and in the claims represented by "electron donor derivative-binder"). In some aspects of these embodiments, the electron donor derivative-binder may be selected from, for example, 9-anthracenemethyl methacrylate/2-hydroxyethyl methacrylate/3-(trimethoxysilyl)propyl methacrylate terpolymer; a quinolin-8-yl methacrylate/2-hydroxyethyl methacrylate copolymer; a 9-anthracenemethyl methacrylate/2-hydroxyethyl methacrylate copolymer; a quinolin-8-yl methacrylate/2-hydroxyethyl methacrylate/3-(trimethoxysilyl)propyl methacrylate terpolymer; a 9-anthracenemethyl methacrylate; a quinolin-8-yl methacrylate; and combinations thereof.

In some embodiments of the present invention, the electron acceptor may be selected from, for example, pentafluoroaniline; phthalocyanine; perfluorophthalocyanine; tetraphenylporphine; 2-(9-dicyanomethylene-spiro[5.5]undec-3-ylidene)-malononitrile; 4-phenylazo-benzene-1,3-diol; 4-(pyridin-2-ylazo)-benzene-1,3-diol; benzo[1,2,5]thiadiazole-4,7-dicarbonitrile; tetracyanoquinodimethane; quinoline; chlorpromazine; fullerene C₆₀ (e.g., Buckminsterfullerene C₆₀); fullerene C₇₀ (e.g., Buckminsterfullerene C₇₀); perylene-3,4:9,10-tetracarboxydiimide; trinitrobenzene; 2-(3-Nitro-benzilidene)-malononitrile; hexacyanobutadiene; anhydrides; derivatives and combinations thereof. In some aspects of these embodiments, the electron acceptor may be selected from fullerene C₆₀; fullerene C₇₀; derivatives thereof; and combinations thereof.

In some embodiments of the present invention, the electron acceptor may be selected from, for example, anhydrides, dianhydrides, imides and diimides (e.g., phthalic, especially those with 4 halogens on the ring; pyromellitic dianhydride; naphthalene-tetracaboxylic-dianhydride (NTCDA); perylene-tetracarboxylic-dianhydride (PTCDA)); benzoquinones (e.g., tetra-halogenated and tetracyano derivatives); naphthoquinones; anthraquinones; cyano-compounds (e.g., tetracyanoethylene (TCNE), TCNQ, AIDCN); nitro compounds having at least three nitro groups (e.g., benzenes, naphthalenes, trinitrofluorenone, nitrated dibenzothiophenedioxide, nitrated phenylsulfones); poly-sulfones (e.g., 1,4-bis(phenylsulfonyl)benzene); viologens; viologen salts; 1,3,5-triazines (e.g., halogen and cyano derivatives thereof); alpha diketones (e.g., indanetrione); sulfur; derivatives; and combinations thereof.

In some embodiments of the present invention, the electric field programmable film composition contains < 1 wt%; alternatively < 0.5 wt%; alternatively ≤ 0.4 wt%; alternatively ≤ 0.3 wt%; alternatively ≤ 0.25 wt%; alternatively ≤ 0.2 wt%; alternatively ≤ 0.1 wt%; alternatively ≤ 0.09 wt%; alternatively ≤ 0.075 wt%; alternatively ≤ 0.05 wt% electron donor (based on total solids).

In some embodiments of the present invention, the electric field programmable film composition contains < 1 wt%; alternatively < 0.5 wt%; alternatively ≤ 0.4 wt%; alternatively ≤ 0.3 wt%; alternatively ≤ 0.25 wt%; alternatively ≤ 0.2 wt%; alternatively ≤ 0.1 wt%; alternatively ≤ 0.09 wt%; alternatively ≤ 0.075 wt%; alternatively ≤ 0.05 wt% electron acceptor (based on total solids).

In some embodiments of the present invention, either the electron donor or the electron acceptor may be provided in relative excess. In some aspects of these embodiments, the electric field programmable film composition will contain a higher concentration of electron donor relative to the concentration of electron acceptor.
In some aspects of these embodiments, the electric field programmable film composition will contain a higher concentration of electron acceptor relative to the concentration of electron donor. In some aspects of these embodiments, the concentration of the electron donor in the electric field programmable film composition is 10 to 250 mmol/hg; alternatively 50 to 200 mmol/hg; alternatively 120 to 200 mmol/hg; alternatively 50 to 150 mmol/hg; and the concentration of the electron acceptor in the electric field programmable film composition is 1 to 300 µmol/hg; alternatively 10 to 200 µmol/hg; alternatively 10 to 150 µmol/hg; alternatively 25 to 125 µmol/hg; alternatively 25 to 100 µmol/hg; alternatively 25 to 75 µmol/hg. In some aspects of these embodiments, the concentration of the electron acceptor in the electric field programmable film composition is 10 to 250 mmol/hg; alternatively 50 to 200 mmol/hg; alternatively 120 to 200 mmol/hg; alternatively 50 to 150 mmol/hg; and the concentration of the electron donor in the electric field programmable film composition is 1 to 300 µmol/hg; alternatively 10 to 200 µmol/hg; alternatively 10 to 150 µmol/hg; alternatively 25 to 125 µmol/hg; alternatively 25 to 100 µmol/hg; alternatively 25 to 75 µmol/hg. The abbreviation "hg" refers to hectograms (100 grams). The selection of whether to provide electron donor or electron acceptor in relative excess may depend on the specific electron acceptor and electron donor used as well as on the desired direction of current flow. Without wishing to be bound by theory, it is believed that, for example, if an anthracene is the electron donor and a fullerene is the electron acceptor and the electron donor is provided in excess relative to the electron acceptor, the predominant charge carriers will be holes that traverse individually from a positively charged anthracene group to a neutral anthracene group. Conversely, it is believed that if the electron acceptor is tetracyanoquinodimethane (TCNQ) and the electron donor is phenothiazine and the acceptor is provided in relative excess, the predominant charge carriers will be electrons, transferred from the phenothiazine to a small number of TCNQ groups, that traverse individually from a negatively charged TCNQ group to a neutral TCNQ group.

In some embodiments of the present invention, the electron acceptor is selected from molecules or derivatives that exhibit an electron affinity greater than 0.8 eV, alternatively greater than 1.2 eV. The selection of the optimum electron acceptor may be influenced by its ionization potential. In some embodiments of the present invention, more than one electron acceptor may be used. In some aspects of these embodiments, the use of more than one electron acceptor may reduce the threshold voltage and/or facilitate preferred properties such as, for example, multiple switching potentials (i.e., multiple bits per cell).

In some embodiments of the present invention, the electron donor is selected from molecules or derivatives that exhibit an ionization potential less than 8.5 eV; alternatively less than 8.0 eV. The selection of the optimum electron donor may be influenced by its ionization potential. In some embodiments of the present invention, more than one electron donor may be used. In some aspects of these embodiments, the use of more than one electron donor may reduce the threshold voltage and/or facilitate preferred properties such as, for example, multiple switching potentials (i.e., multiple bits per cell).

Note that some molecules or derivatives have an electron affinity and ionization potential such that they may function as either an electron donor or an electron acceptor depending on the selection of the other components of the electric field programmable film composition (e.g., phthalocyanine). Without wishing to be bound by theory, in comparing two molecules or derivatives, the molecule or derivative with the lowest ionization potential is usually considered to be the electron donor, while that with the highest electron affinity is considered the electron acceptor.

In some embodiments of the present invention, the electric field programmable film composition may further comprise an optional donor-acceptor complex, which may operate to adjust the properties of the film, for example, the film's "on" and "off" threshold voltages, "on" state currents and/or "off" state currents. In some aspects of these embodiments, the electric field programmable film composition may contain 0.05 to 5 wt%, alternatively 0.5 to 4 wt%, alternatively 1 to 3.5 wt%, alternatively 1.5 to 3 wt% of the optional donor-acceptor complex. In some aspects of these embodiments, the electric field programmable film composition may comprise an optional donor-acceptor complex selected from, for example, tetrathiafulvalene--tetracyanoquinodimethane; hexamethylenetetrathiafulvalene-tetracyanoquinodimethane; tetraselenafulvalene--tetracyanoquinodimethane; hexamethylenetetraselenafulvalene--tetracyanoquinodimethane; methylcarbazole-tetracyanoquinodimethane; tetramethyltetraselenofulvalene--tetracyanoquinodimethane; ferrocene--tetracyanoquinodimethane; (tetrathiotetracene, tetramethyl-p-phenylenediamine, or hexamethylbenzene)--tetracyanoquinodimethane; (tetrathiafulvalene, hexamethylenetetrathiafulvalene, tetraselenafulvalene, hexamethylenetetraselenafulvalene, or tetramethyltetraselenofulvalene)--N-alkylcarbazole(C₁-C₁₀, linear or branched); (tetrathiotetracene, tetramethyl-p-phenylenediamine, or hexamethylbenzene)-Buckminsterfullerene C₆₀; (tetrathiotetracene, tetramethyl-p-phenylenediamine, or hexamethylbenzene)--Buckminsterfullerene C₇₀; (tetrathiotetracene, tetramethyl-p-phenylenediamine, or hexamethylbenzene)--tetracyanobenzene; (tetrathiotetracene, tetramethyl-p-phenylenediamine, or hexamethylbenzene)-tetracyanoethylene; (tetrathiotetracene, tetramethyl-p-phenylenediamine, or hexamethylbenzene)--p-chloranil; and combinations thereof.

In some embodiments of the present invention, the electron donor and the electron acceptor may be provided as a donor-acceptor complex or may form a donor-acceptor complex *in-situ* when added to a binder. The extent to which electron donors and electron acceptors form donor-acceptor complexes *in-situ* may depend on the law of mass action. Alternatively, in some embodiments of the present invention, donor-acceptor complexes may disproportionate *in-situ* when added to a binder, resulting in non-ionized electron donors and electron acceptors.

In some embodiments of the present invention, the electric field programmable film composition may optionally contain processing agents including, for example, surfactants, mold release agents, accelerators, anti-oxidants, thermal stabilizers, anti-ozonants, fillers and fibers.

The electric field programmable film may be manufactured by a variety of conventional different methods. For example, one method of manufacturing the film, an electric field programmable film composition of the present invention may be deposited on a substrate. The deposited film composition may then be dried and/or cured to form the electric field programmable film. Alternatively, the electric field programmable film composition may be cast in the presence of an optional solvent. The electric field programmable film may then be cast from solution and the solvent evaporated. Some methods for casting the film include, for example, spin coating, spray coating, electrostatic coating, dip coating, blade coating and slot coating. Alternatively, the electric field programmable film may be manufactured by processes including, for example, injection molding, vacuum forming, blow molding and compression molding.

Substrates suitable for use with the present invention include, for example, semiconducting substrates (e.g., doped silicon wafers) and conducting substrates (e.g., aluminum, titanium, vanadium, chromium, manganese, iron, cobalt, nickel, copper, zinc, zirconium, niobium, molybdenum, ruthenium, rhodium, palladium, silver, cadmium, hafnium, tantalum, tungsten, rhenium, osmium, iridium, platinum, gold mercury, tin, germanium, lead, and alloys thereof). In some embodiments of the present invention, the substrate may be patterned.

In some embodiments of the present invention, the electric field programmable film may have a thickness of 5 to 5000 nanometers (nm), depending on the requirements of the device it is incorporated into. In general, the switching voltages are linear in the film thickness. In some aspects of these embodiments, when incorporated into a device requiring switching voltage magnitudes below about 10 V, the electric field programmable film exhibits a film thickness (after optional curing) of about 10 to 100 nm. In some aspects of these embodiments, when incorporated into a device requiring switching voltage magnitudes below about 5 V, the electric field programmable a film exhibits a thickness (after optional curing) of 5 to 50 nm.

In some embodiments of the present invention, the electric field programmable film may be used in a cross point array. When the film is used in a cross point array, the electrodes may be electrically coupled to the electric field programmable film. The cross point array may advantageously include an electrical coupling element. An electrical coupling element can provide ohmic contact, contact via a conducting plug, capacitive contact, contact via an intervening tunnel junction, or contact via an intervening isolation device such as a diode or a transistor or contact via other electrical devices.

The electric field programmable film obtained from the electric field programmable film composition may be used in electronic memory and switching devices or data storage devices. These devices may contain either a single film or multiple films. Devices having multiple films are generally termed stacked devices.

In some embodiments of the present invention, the electric field programmable film may be used as a medium for mass data storage. In one aspect of this embodiment, the field programmable film may have a thickness of 5 to 500 nm; alternatively 10 to 200 nm; alternatively 10 to 100 nm. In some aspects of this embodiment, the film may be disposed on a conducting or semiconducting substrate.

In a memory or data storage mode, programming, reading and erasing the memory cell can be accomplished by applying to the cell a voltage above the threshold voltage to place it in the "on" condition, applying to the cell a sub-threshold voltage to read the cell to determine whether it is "on" or "off" and applying to the cell a sufficiently negative voltage to turn the cell "off."

In some embodiments of the present invention, data storage may be achieved by applying a voltage pulse sequence at appropriate levels to read, write, and erase the cell as desired. In some aspects of these embodiments, the applied voltage may be approximately 0.5 Volts (V) to 12V to write, 0.2V to 10V to read, and -0.5V to -12V to erase the cell. Alternatively, the applied voltage may be approximately 0.5V to 5V to write, 0.2V to 4V to read, and -0.5 to -5V to erase. One skilled in the art will immediately recognize that the voltage applied for the read must be less than the write voltage to avoid a "read disturb", or unintentional write of the cell. The duration of the pulses may be 0.5 to 10,000 nanoseconds, alternatively 2 to 100 nanoseconds, alternatively 1 to 50 nanoseconds.

In some embodiments of the present invention, data storage may be achieved by applying a series of voltage pulses, an alternating current (AC), a direct current (DC), or a DC biased AC electrical signal of sufficient amplitude to drive the electric field programmable film of the present invention into the conductive or on state. In some aspects of these embodiments, the electrical signal may be -10 V to 10 V, using a conducting tip such as that used in scanning probe microscopy. In some aspects of these embodiments, the AC signal may be 0.5 kHz to 100 MHz; alternatively 10 kHz to 1 MHz. The field can be applied by the tip in contact mode or non contact mode and results in a conductive domain within the field programmable film having a diameter of about 0.5 nm to about 500 nm; alternatively 0.5 to about 50 nm. The domain can be read by a scanning force microscope tip using an AC, DC or DC biased AC signal of about -10 V to about 10 V in either contact or non contact mode while monitoring current, impedance, voltage drop, capacitance, tapping phase shift or any combination of the foregoing. In addition, the field programmable film can be written, erased or read by optical means or a combination of optical means and one or more of the forgoing electrical signals. The size of the conductive domain can be optimized for the desired application. For example, domains that are readable with a scanning probe microscope tip can be about 1 nm to about 100 nm while domains readable with a laser probe such as might be found in a CD player can have diameters of about 100 nm to about 500 nm. In this way, the field programmable film can be programmed in configurations where at least one of the electrodes is not held in a fixed position relative to the surface of the field programmable film. An example of an apparatus for storing information in this way is set forth in patent application WO 02/077986.

Some embodiments of the present invention will now be described in detail in the following Examples.

### Example 1

### Preparation of 9-anthracenemethyl methacrylate

A two liter, 3-necked round bottomed flask was equipped with a condenser, drop addition funnel, mechanical stirrer and gas inlet tube. The flask was then charged with 9-anthracenemethanol (48.9 g, 0.235 mol) and purged with nitrogen for 10 minutes. Anhydrous tetrahydrofuran (300 mL), pyridine (33 mL) and triethylamine (50 mL) were then added to the flask, with agitation. The resulting solution was cooled to 0°C, with agitation. Methacryloyl chloride (technical grade, 37.5 mL, 40.1 g, 0.345 mol) was added into the addition funnel using a syringe, and slowly added dropwise over the course of an hour from the addition funnel into the flask with vigorous agitation. A brownish precipitate formed and aggregated into a gummy mass, which periodically interfered with stirring. The reaction was maintained at a temperature of 0°C for 2 hours and was then allowed to gradually warm up to room temperature overnight. The reaction was then quenched with water (400 mL). Ethyl ether (300 mL) was added to the flask, and the phases were separated in a two liter separatory funnel. The organic phase was washed successively with 20% aqueous hydrochloric (HCl) (400 mL), saturated aqueous sodium bicarbonate (NaHCO₃) (800 mL), and saturated aqueous sodium chloride (NaCl) (400 mL). The organic phase was then dried over sodium sulfate (Na₂SO₄), filtered, and the solvent was removed in vacuo. The resulting crude product was recrystallized in two batches using methanol (MeOH) (400 mL).

### Example 2

### Preparation of quinolin-8-yl methacrylate

Quinolin-8-yl methacrylate was prepared using the same process described in Example 1 except with the substitution of 8-hydroxyquinoline (34.1 g, 0.235 mol) in the place of the 9-anthracemethanol.

### Example 3

### Prep. 9-anthracenemethyl methacrylate/2-hydroxyethyl methacrylate copolymer

A 500 mL, 3-necked round bottom flask was fitted with a condenser and gas inlet tube and purged with nitrogen for 15 minutes. The flask was then charged with degassed tetrahydrofuran (THF) (120 mL), 9-anthracenemethyl methacrylate (ANTMA) (10.0 g, 36.2 mmol) and 2-hydroxyethyl methacrylate (HEMA) (9.3 mL, 10.0 g, 76.8 mmol), with agitation. To this mixture was then added 1,1'-azobis-(cyclohexane carbonitrile) (commercially available from Du Pont as VAZO 88) (0.57 g, 2.33 mmol, 2.85 % w/w), with agitation. The flask contents were then heated to reflux. After refluxing for 24 hours, an additional portion of 1,1'-azobis-(cyclohexane carbonitrile) (0.89 g, 3.64 mmol, 4.45 % w/w) was added. The flask contents were then refluxed for another 24 hours. The flask contents were then cooled to room temperature. The contents of the flask were then poured into 500 mL of a hexane/ethyl ether solution containing 20 volume percent of hexane in ethyl ether to precipitate the polymer. The solid polymer was collected by suction filtration and dried in vacuo to yield 19.5 g (98%) as a fluffy white solid.

### Example 4

### Preparation of quinolin-8-yl methacrylate/2-hydroxyethyl methacrylate copolymer

Quinolin-8-yl methacrylate/2-hydroxyethyl methacrylate copolymer was prepared using the same process described in Example 3 except with the substitution of quinolin-8-yl methacrylate (7.71 g, 36.2 mmol) in place of the 9-anthracenemethyl methacrylate.

### Example 5

### Preparation of 9-anthracenemethyl methacrylate/2-hydroxyethyl methacrylate/3-(trimethoxysilyl)propyl methacrylate terpolymer

A 500 mL, round bottomed sidearm flask (the "reactant reservoir") was charged with propylene glycol methyl ether acetate (PGMEA) (117.5 g), 9-anthracenemethyl methacrylate (46.0 g, 166 mmol), 2-hydroxyethyl methacrylate (6.82 g, 52.4 mmol), 3-(trimethoxysilyl)propyl methacrylate (22.2 grams, 89.4 mmol) and t-amyl peroxy pivalate (7.5 g, 39.8 mmol). The reactant reservoir was fitted with a rubber septum cap. An outlet tube, connected to an electronically controlled pump was inserted through the septum cap. A 1 liter, 3-neck flask with bottom valve (the "reaction vessel") was equipped with a heating mantle, a variable autotransformer, a Friedrich's condenser, a mechanical stirrer, a Claisen head, a thermal probe (thermocouple connected to an power controller) and a nitrogen inlet. The reaction vessel was charged with PGMEA (275 g). The temperature of the reaction vessel was raised to 85° C and allowed to equilibrate. The contents of the reactant reservoir were fed into the reaction vessel at a reactant feed rate of approximately 1.69 mL/min using an electronically controlled pump (manufactured by SciLog), previously calibrated for flow rate with PGMEA, such that a total reactant feed time of about 120 minutes was achieved. Upon completion of the reactant feed, the contents of the reaction vessel were maintained at 85° C for 30 minutes with agitation. Then degassed t-amyl peroxy pivalate (7.5 g, 27.5 mmol) and PGMEA (25 g) were fed into the reaction vessel at a rate of about 1.14 mL/minute, while maintaining the contents of the reaction vessel at 85° C with agitation. Following complete addition of the degassed t-amyl peroxy pivalate and PGMEA, the contents of the reaction vessel were maintained at 85° C with agitation for an additional hour. The contents of the reaction vessel were then cooled to room temperature and transferred to a suitable container.

### Example 6

### Preparation of quinolin-8-yl methacrylate/2-hydroxyethyl methacrylate/3-(trimethoxysily)propyl methacrylate terpolymer

Quinolin-8-yl methacrylate/2-hydroxyethyl methacrylate/3-(trimethoxysily)propyl methacrylate terpolymer was prepared using the same process described in Example 5 except with the substitution of quinolin-8-yl methacrylate (35.4 g, 166 mmol) in place of the 9-anthracenemethyl methacrylate and the reactant feed rate was about 1.60 mL/min such that the total time of addition was 120 minutes.

### Example 7

### Preparation of 9-anthracenemethyl methacrylate/methyl methacrylate/2-hydroxyethyl methacrylate terpolymer

THF (249 kg) was charged to a 100 gallon (approximately 380 L) reactor using residual vacuum. 9-Anthracenemethyl methacrylate (ANTMA)(21.05 kg) was added to the reactor and mixed with THF until dissolved. The pre-weighed quantities of methyl methacrylate (MMA) (16.00 kg), 2-hydroxyethyl methacrylate (HEMA)(12.5 kg), and asobisisobutryonitrile (AIBN, commercially available under the trade designation "VAZO 64") (200 g) were added to the reactor. The reaction mixture was agitated under vacuum and purged with nitrogen three times to remove dissolved oxygen. After the final nitrogen purging, the reactor contents were heated to 66° C. The reactor contents were maintained at 66° C and atmospheric pressure for 30 hrs. The reactor contents were cooled down to room temperature and transferred in several increments through a spray nozzle to a precipitation vessel containing methyl tert-butyl ether (MTBE) forming a slurry. The slurry was filtered using a 48 inch (approximately 122 cm) Hastelloy Buchner funnel fitted with a 10 µm polypro filter bag. The wet cake was washed with additional MTBE. A dam was placed on the filter cake on the Buchner Funnel and air was passed over the filter cake to remove the MTBE and dry the cake. The cake was broken up and over dried in vacuo to provide the product terpolymer.

### Example 8

### Prophetic preparation of quinolin-8-yl methacrylate/methyl methacrylate/2-hydroxyethyl methacrylate terpolymer

Quinolin-8-yl methacrylate/methyl methacrylate/2-hydroxyethyl methacrylate terpolymer is prepared using the process described in Example 5 except with the substitution of an equivalent molar amount of quinolin-8-yl methacrylate (16.23 kg) in place of the 9-anthracenemethyl methacrylate.

### Example 9

### Prophetic preparation of N-vinyl-phenothiazine (NVP)/methyl methacrylate/2-hydroxyethyl methacrylate terpolymer

N-vinyl-phenothiazine (NVP)/methyl methacrylate/2-hydroxyethyl methacrylate terpolymer is prepared using the process described in Example 7 except with the substitution of an equivalent molar amount of N-vinyl-phenothiazine (17.16 kg) in place of the 9-anthracenemethyl methacrylate. The N-vinyl-phenothiazine may be synthesized in the manner set forth in Reppe et al., German patent DE 946,542 (1956).

### Example 10

### Prophetic formulation

The formulation is prepared by combining the following in a container with agitation: Active polymer: 9-anthracenemethyl methacrylate/2-hydroxyethyl methacrylate copolymer obtained from Example 3 (10 g); Electron Acceptor: C₆₀, Buckminsterfullerene (2.16 mg, 30 µmol/hg solids); and Solvent: 50/50 w/w blend of methoxybenzene and 2-heptanone (240 g). The contents of the container are agitated overnight on a laboratory roller to dissolve the components. The contents of the container are then sonicated in an ultrasonic bath for 10 minutes and filtered through a 0.2 micrometer membrane filter to collect the product formulation.

### Example 11

### Prophetic Test Memory Cell

A test memory cell may be fabricated by spin coating the formulation of Example 10 on a p-type silicon wafer having a diameter of 100 millimeters (mm) and a resistivity of about 0.0001 to about 0.1 ohm-cm at a spin speed from about 500 to about 4000 rpm with a typical spin speed of about 2500 rpm. The coated silicon wafer may then be baked on a hotplate at 250° C for 60 seconds to give a film having a thickness of about 20 to about 100 nm. The average film thickness should be about 50 nm. Aluminum dots of about 0.5 mm in diameter and about 45 nm of thickness may then be evaporated thermally on top of the film through a shadow mask at a pressure of about 10⁻⁶ to 5 x 10⁻⁵ torr (1.33 x 10⁻³ to 6.65 x 10⁻² Pascals). Current-voltage characteristics may be measured using a Keithley 2400 source meter with the silicon wafer configured as a ground terminal and the aluminum electrode configured as a working electrode. The entire measurement may be done under the control of software written in Visual Basic (Microsoft Corporation), programmed to sweep from 0.0 V to about 10.0 V, from 10.0 V to 0.0 V and from 0.0 V to -10.0 V and from -10.0 V to 0.0 V with the voltage limits being adjustable. The voltage range may be adjusted to avoid overdriving the cell during the positive and negative voltage sweeps. The currents in the off state may generally be less than or equal to about 10 microamperes (µA) while typical currents in the on state may generally be greater than or equal to about 100 µA.

### Example 12

### Prophetic preparation of Memory Composition

A memory composition is prepared by dissolving together the following: Active polymer: Polymer of Example 3 (1.0 g); Electron acceptor: C₆₀ Buckminsterfullerene from Aldrich Chemical Co. (0.144 mg, 20 µmol/hg); and, Solvent: 50/50 w/w blend of methoxybenzene and 2-heptanone (24 g). After dissolution, the solution is filtered through a polypropylene filter with a 0.2 µm pore. The memory composition may be prepared and tested using the procedure set forth in Example 11.

### Example 13

### Prophetic preparation of crosslinkable memory composition

A crosslinkable memory composition is prepared by dissolving together the following: Active polymer: the polymer of Example 3 (0.884 g); Crosslinker: Powderlink 1174 glycouryl crosslinker from Cytec Industries, (0.111 g); Catalyst: p-toluenesulfonic acid monohydrate (PTSA) from Aldrich Chemical Co. (0.005 g); Electron acceptor: C₆₀ Buckminsterfullerene from Aldrich Chemical Co. (0.144 mg, 20 µmol/hg); and, Solvent: 50/50 w/w blend of methoxybenzene and 2-heptanone (24 g). After dissolution, the solution is filtered through a polypropylene filter with a 0.2 µm pore size. The memory composition may be prepared and tested using the procedure set forth in Example 11.

### Example 14

### Prophetic preparation of memory composition

A memory composition is prepared by dissolving together the following: Active polymer: polymer of Example 3 (0.25 g); Diluent: Novolak resin having a composition of 30% m-cresol and 70% p-cresol, available from Meiwa Plastic Industries, Ube City, Yamaguchi, 755-0067 Japan, (0.75 g); Electron acceptor: C₆₀ Buckminsterfullerene from Aldrich Chemical Co. (0.144 mg, 20 µmol/hg); and, Solvent: 50/50 w/w blend of methoxybenzene and 2-heptanone (24 g). After dissolution, the solution is filtered through a polypropylene filter with a 0.2 µm pore size. The memory composition may be prepared and tested using the procedure set forth in Example 11.

### Example 15

### Prophetic preparation of crosslinkable memory composition

A crosslinkable memory composition is prepared by dissolving together the following: Active polymer: the polymer of Example 3 (0.221 g); Diluent: Novolak resin having a composition of 30% m-cresol and 70% p-cresol, available from Meiwa Plastic Industries, Ube City, Yamaguchi, 755-0067 Japan, (0.663 g); Crosslinker: Powderlink 1174 glycouryl crosslinker from Cytec Industries, (0.111 g); Catalyst: p-toluenesulfonic acid monohydrate from Aldrich Chemical Co. (0.005 g); Electron Acceptor: C₆₀ Buckminsterfullerene from Aldrich Chemical Co. (0.144 mg, 20 µ.g/hg); and, Solvent: a 50/50 w/w blend of methoxybenzene and 2-heptanone (24 g). After dissolution, the solution is filtered through a polypropylene filter with a 0.2 µm pore size. The memory composition may be prepared and tested using the procedure set forth in Example 11.

### Examples 16-73

### Preparation of memory compositions

The memory compositions in prophetic Examples 16-23, 26-45, 48-50, 52-70 and 72 are prepared using the procedure described in the Example noted in Table 2 except that the materials added together to obtain the memory composition are substituted with the materials and amounts noted below in Table 2. The memory compositions in Examples 24-25, 46-47, 51, 71 and 73 were prepared using the procedure described in the Example noted in Table 2 except that the materials added together to obtain the memory composition were substituted with the materials and amounts noted below in Table 2. The electron acceptor loading is expressed in micromoles/hg of total solids.

A key for the raw materials listed in Table 2 is provided below in Table 1 with Table 2 identifier, chemical name and commercial source for the materials listed.

**Table 1**

| **Table 2 Identifier** | **Generic Chemical Name** | **Trade Name** | **Source** |
|---|---|---|---|
| Novolak | 30% m-cresol and 70% p-cresol | Novolak | Meiwa Plastic Industries |
| TCNQ | 7,7,8,8-Tetracyanoquinodimethane | TCNQ | Aldrich |
| PDL | Highly monomeric, mostly tetramethoxymethyl glucoluril crosslinking agent | Powderlink® 1174 Powder Coating Resin | Cytec Industries |
| PTSA | p-toluenesulfonic acid monohydrate | PTSA | Aldrich |
| DXP | *N,N'*-Bis(2,6-dimethylphenyl) perlene-3,4,9,10-tetracarboxylic diimide | DXP | Aldrich |
| F-C₆₀ | Fullerene-C₆₀ | Buckminsterfullerene C₆₀ | Aldrich |
| F-C₇₀ | Fullerene-C₇₀ | Buckminsterfullerene C₇₀ | Aldrich |

**Table 2**

| **Ex.** | **As in Ex.** | **Active Polymer: (Product)** | **Diluent** | **Electron Acceptor** | **X-linker** | **Catalyst** |
|---|---|---|---|---|---|---|
| 16 | 12 | Ex. 3 (1.0 g) | - | TCNQ (0.0613 mg, 30 µmol/hg solids) | - | - |
| 17 | 13 | Ex. 3 (0.884 g) | - | TCNQ (0.0613 mg, 30 µmol/hg solids) | PDL (0.111 g) | PTSA (0.005 g) |
| 18 | 14 | Ex. 3 (0.25 g) | Novolak (0.75 g) | TCNQ (0.0613 mg, 30 µmol/hg solids) | - | - |
| 19 | 15 | Ex. 3 (0.221 g) | Novolak (0.663 g) | TCNQ (0.0613 mg, 30 µmol/hg solids) | PDL (0.111 g) | PTSA (0.005 g) |
| 20 | 12 | Ex.4 (1.0 g) | - | DXP (0.18 mg, 30 µmol/hg solids) | - | - |
| 21 | 13 | Ex. 4 (0.884 g) | - | DXP (0.18 mg, 30 µmol/hg solids) | PDL (0.111 g) | PTSA (0.005 g) |
| 22 | 14 | Ex.4 (0.25 g) | Novolak (0.75 g) | DXP (0.18 mg, 30 µmol/hg solids) | - | - |
| 23 | 15 | Ex. 4 (0.221 g) | Novolak (0.663 g) | DXP (0.18 mg, 30 µmol/hg solids) | PDL (0.111 g) | PTSA (0.005 g) |
| **24** | 12 | Ex. 5 (1.0 g) | - | F-C₆₀ (2.16 mg, 30 µmol/hg solids) | - | - |
| **25** | 14 | Ex. 5 (0.25 g) | Novolak (0.75 g) | F-C₆₀ (2.16 mg, 30 µmol/hg solids) | - | - |
| 26 | 12 | Ex. 5 (1.0 g) | - | TCNQ (0.0613 mg, 30 µmol/hg solids) | - | - |
| 27 | 14 | Ex. 5 (0.25 g) | Novolak (0.75 g) | TCNQ (0.0613 mg, 30 µmol/hg solids) | - | - |
| 28 | 12 | Ex. 6 (1.0g) | - | DXP (0.18 mg, 30 µmol/hg solids) | - | - |
| 29 | 14 | Ex. 6 (0.25 g) | Novolak (0.75 g) | DXP (0.18 mg, 30 µmol/hg solids) | - | - |
| 30 | 12 | Ex. 6 (1.0 g) | - | F-C₆₀ (2.16 mg, 30 µmol/hg solids) | - | - |
| 31 | 14 | Ex. 6 (0.25 g) | Novolak (0.75 g) | F-C₆₀ (2.16 mg, 30 µmol/hg solids) | - | - |
| 32 | 12 | Ex.6 (1.0 g) | - | TCNQ (0.0613 mg, 30 µmol/hg solids) | - | - |
| 33 | 14 | Ex. 6 (0.25 g) | Novolak (0.75 g) | TCNQ (0.0613 mg, 30 µmol/hg solids) | - | - |
| 34 | 12 | Ex. 6 (1.0 g) | - | DXP (0.18 mg, 30 µmol/hg solids) | - | - |
| 35 | 14 | Ex. 6 (0.25 g) | Novolak (0.75 g) | DXP (0.18 mg, 30 µmol/hg solids) | - | - |
| 36 | 12 | Ex. 7 (1.0 g) | - | TCNQ (0.0613 mg, 30 µmol/hg solids) | - | - |
| 37 | 13 | Ex. 7 (0.884 g) | - | TCNQ (0.0613 mg, 30 µmol/hg solids) | PDL (0.111 g) | PTSA (0.005 g) |
| 38 | 14 | Ex. 7 (0.25 g) | Novolak (0.75 g) | TCNQ (0.0613 mg, 30 µmol/hg solids) | - | - |
| 39 | 15 | Ex. 7 (0.221 g) | Novolak (0.663 g) | TCNQ (0.0613 mg, 30 µmol/hg solids) | PDL (0.111 g) | PTSA (0.005 g) |
| 40 | 12 | Ex. 7 (1.0 g) | - | DXP (0.18 mg, 30 µmol/hg solids) | - | - |
| 41 | 13 | Ex. 7 (0.884 g) | - | DXP (0.18 mg, 30 µmol/hg solids) | PDL (0.111 g) | PTSA (0.005 g) |
| 42 | 14 | Ex. 7 (0.25 g) | Novolak (0.75 g) | DXP (0.18 mg, 30 µmol/hg solids) | - | - |
| 43 | 15 | Ex. 7 (0.221 g) | Novolak (0.663 g) | DXP (0.18 mg, 30 µmol/hg solids) | PDL (0.111 g) | PTSA (0.005 g) |
| 44 | 12 | Ex. 7 (1.0 g) | - | F-C₆₀ (0.144 mg, 20 µmol/hg solids) | - | - |
| 45 | 13 | Ex. 7 (0.884 g) | - | F-C₆₀ (0.144 mg, 20 µmol/hg solids) | PDL (0.111 g) | PTSA (0.005 g) |
| **46** | 14 | Ex. 7 (0.25 g) | Novolak (0.75 g) | F-C₆₀ (0.144 mg, 20 µmol/hg solids) | - | - |
| **47** | 15 | Ex. 7 (0.221 g) | Novolak (0.663 g) | F-C₆₀ (0.144 mg, 20 µmol/hg solids) | PDL (0.111 g) | PTSA (0.005 g) |
| 48 | 12 | Ex. 7 (1.0 g) | - | F-C₇₀ (0.168 mg, 20 µmol/hg solids) | - | - |
| 49 | 13 | Ex. 7 (0.884 g) | - | F-C₇₀ (0.168 mg, 20 µmol/hg solids) | PDL (0.111 g) | PTSA (0.005 g) |
| 50 | 14 | Ex. 7 (0.25 g) | Novolak (0.75 g) | F-C₇₀ (0.168 mg, 20 µmol/hg solids) | - | - |
| **51** | 15 | Ex. 7 (0.221 g) | Novolak (0.663 g) | F-C₇₀ (0.168 mg, 20 µmol/hg solids) | PDL (0.111 g) | PTSA (0.005 g) |
| 52 | 12 | Ex. 8 (1.0 g) | - | TCNQ (0.0613 mg, 30 µmol/hg solids) | - | - |
| 53 | 13 | Ex. 8 (0.884 g) | - | TCNQ (0.0613 mg, 30 µmol/hg solids) | PDL (0.111 g) | PTSA (0.005 g) |
| 54 | 14 | Ex. 8 (0.25 g) | Novolak (0.75 g) | TCNQ (0.0613 mg, 30 µmol/hg solids) | - | - |
| 55 | 15 | Ex. 8 (0.221 g) | Novolak (0.663 g) | TCNQ (0.0613 mg, 30 µmol/hg solids) | PDL (0.111 g) | PTSA (0.005 g) |
| 56 | 12 | Ex. 8 (1.0 g) | - | DXP (0.18 mg, 30 µmol/hg solids) | - | - |
| 57 | 13 | Ex. 8 (0.884 g) | - | DXP (0.18 mg, 30 µmol/hg solids) | PDL (0.111 g) | PTSA (0.005 g) |
| 58 | 14 | Ex. 8 (0.25 g) | Novolak (0.75 g) | DXP (0.18 mg, 30 µmol/hg solids) | - | - |
| 59 | 15 | Ex. 8 (0.221 g) | Novolak (0.663 g) | DXP (0.18 mg, 30 µmol/hg solids) | PDL (0.111 g) | PTSA (0.005 g) |
| 60 | 12 | Ex. 8 (1.0 g) | - | F-C₆₀ (0.144 mg, 20 µmol/hg solids) | - | - |
| 61 | 13 | Ex. 8 (0.884 g) | - | F-C₆₀ (0.144 mg, 20 µmol/hg solids) | PDL (0.111 g) | PTSA (0.005 g) |
| 62 | 14 | Ex. 8 (0.25 g) | Novolak (0.75 g) | F-C₆₀ (0.144 mg, 20 µmol/hg solids) | - | - |
| 63 | 15 | Ex. 8 (0.221 g) | Novolak (0.663 g) | F-C₆₀ (0.144 mg, 20 µmol/hg solids) | PDL (0.111 g) | PTSA (0.005 g) |
| 64 | 12 | Ex. 8 (1.0 g) | - | F-C₇₀ (0.168 mg, 20 µmol/hg solids) | - | - |
| 65 | 13 | Ex. 8 (0.884 g) | - | F-C₇₀ (0.168 mg, 20 µmol/hg solids) | PDL (0.111 g) | PTSA (0.005 g) |
| 66 | 14 | Ex. 8 (0.25 g) | Novolak (0.75 g) | F-C₇₀ (0.168 mg, 20 µmol/hg solids) | - | - |
| 67 | 15 | Ex. 8 (0.221 g) | Novolak (0.663 g) | F-C₇₀ (0.168 mg, 20 µmol/hg solids) | PDL (0.111 g) | PTSA (0.005 g) |
| 68 | 12 | Ex. 7 (1.0 g) | - | F-C₆₀ (0.216 mg, 30 µmol/hg solids) | - | - |
| 69 | 13 | Ex.7 (0.884 g) | - | F-C₆₀ (0.216 mg, 30 µmol/hg solids) | PDL (0.111 g) | PTSA (0.005 g) |
| 70 | 14 | Ex. 7 (0.25 g) | Novolak (0.75 g) | F-C₆₀ (0.216 mg, 30 µmol/hg solids) | - | - |
| **71** | 15 | Ex. 7 (0.221 g) | Novolak (0.663 g) | F-C₆₀ (0.216 mg, 30 µmol/hg solids) | PDL (0.111 g) | PTSA (0.005 g) |
| 72 | 14 | Ex. 7 (0.5 g) | Novolak (0.5 g) | F-C₆₀ (0.216 mg, 30 µmol/hg solids) | - | - |
| **73** | 15 | Ex. 7 (0.442 g) | Novolak (0.442 g) | F-C₆₀ (0.216 mg, 30 µmol/hg solids) | PDL (0.111 g) | PTSA (0.005 g) |

## Claims

1. An electric field programmable film composition comprising a formulation selected from formulation A and formulation B;
wherein formulation A comprises a binder, an electron donor and an electron acceptor; where at least one of the electron donor and the electron acceptor is chemically bound to the binder; and,
wherein formulation B comprises a binder, an electron donor and an electron acceptor; wherein formulation B contains less than 0.05 wt% of at least one of the electron donor and the electron acceptor.

2. The electric field programmable film composition of claim 1, wherein at least some of the electron donor and at least some of the electron acceptor form a donor-acceptor complex.

3. The electric field programmable film composition of claim 1, wherein the electric field programmable film further comprises a donor-acceptor complex.

4. The electric field programmable film composition of claim 1, wherein electron donor is an electron donor derivative chemically bound to the binder ("electron donor derivative-binder"), wherein the electron donor derivative-binder is selected from 9-anthracenemethyl methacrylate/2-hydroxyethyl methacrylate/3-(trimethoxysilyl)propyl methacrylate terpolymer; a quinolin-8-yl methacrylate/2-hydroxyethyl methacrylate copolymer; a 9-anthracenemethyl methacrylate/2-hydroxyethyl methacrylate copolymer; a quinolin-8-yl methacrylate/2-hydroxyethyl methacrylate/3-(trimethoxysilyl)propyl methacrylate terpolymer; a 9-anthracenemethyl methacrylate; a quinolin-8-yl methacrylate; and combinations thereof.

5. The electric field programmable film composition of claim 1, wherein the electron donor is selected from anthracene; tetrathiafulvalene; 4,4',5-trimethyltetrathiafulvalene; bis(ethylenedithio)tetrathiafulvalene; p-phenylenediamine; carbazole; substituted carbazole; tetrathiotetracene; hexamethylbenzene; tetramethyltetraselenofulvalene; hexamethylenetetraselenofulvalene; 8-hydroxyquinoline; phenyl azorecorcinol; N,N'-bis (3-methylphenyl)-N,N'-diphenylbenzidine; phenothiazine; substituted phenothiazines; pyrene, acenaphthylene; acridine; triphenylene; phthalocyanine; 2-amino-1H-imidazole-4,5-dicarbonitrile (AIDCN); substituted AIDCN; derivatives thereof; and combinations thereof.

6. The electric field programmable film composition of claim 1, wherein the electron acceptor is selected from pentafluoroaniline; phthalocyanine; perfluorophthalocyanine; tetraphenylporphine; 2-(9-dicyanomethylene-spiro[5.5]undec-3-ylidene)-malononitrile; 4-phenylazo-benzene-1,3-diol; 4-(pyridin-2-ylazo)-benzene-1,3-diol; benzo[1,2,5]thiadiazole-4,7-dicarbonitrile; tetracyanoquinodimethane; quinoline; chlorpromazine; fullerene C₆₀ (e.g., Buckminsterfullerene C₆₀); fullerene C₇₀ (e.g., Buckminsterfullerene C₇₀); perylene-3,4:9,10-tetracarboxydiimide; trinitrobenzene; 2-(3-Nitro-benzilidene)-malononitrile; hexacyanobutadiene; anhydrides; derivatives and combinations thereof.

7. The electric field programmable film composition of claim 1, wherein the electron acceptor is selected from fullerene C₆₀; fullerene C₇₀; derivatives thereof; and combinations thereof.

8. The electric field programmable film composition of claim 1, wherein the concentration of the electron donor in the electric field programmable film composition is 10 to 250 mmol/hg of total solids in the electric field programmable film composition and
wherein the concentration of the electron acceptor in the electric field programmable film composition is 10 to 300 µmol/hg of total solids in the electric field programmable film composition.

9. The electric field programmable film composition of claim 1, wherein the concentration of the electron acceptor in the electric field programmable film composition is 10 to 250 mmol/hg of total solids in the electric field programmable film composition and
wherein the concentration of the electron acceptor in the electric field programmable film composition is 10 to 300 µmol/hg of total solids in the electric field programmable film composition.

10. The electric field programmable film composition of claim 1, wherein the binder is crosslinked.

11. A method for preparing an electric field programmable film comprising depositing on a substrate an electric field programmable film composition of claim 1.

12. A memory device comprising the electric field programmable film of claim 11.

13. A machine comprising the memory device of claim 12.
